# EUROPEAN PATENT APPLICATION

(11) **EP 4 535 438 A1**
(43) Date of publication of application: **09.04.2025**
(21) Application number: 23812179.2
(22) Date of filing: 25.05.2023
(51) Int. Cl.: H01L 33/54, H01L 33/50, H01L 33/58, H01L 33/48

(54) **LIGHT EMITTING DIODE PACKAGE**

(30) Priority: 25.05.2022 KR 20220064360
(71) Applicant: Seoul Semiconductor Co., Ltd., Gyeonggi-do 15429 (KR)
(72) Inventor: BAN, Hee Jeong, Ansan-si Gyeonggi-do 15429 (KR)
(74) Representative: Stolmár & Partner Patentanwälte PartG mbB
(86) International application number: PCT/KR2023/007207
(87) International publication number: WO 2023/229405

(57) **Abstract**

The present disclosure relates to a light emitting diode package. Particularly, according to one embodiment of the present disclosure, there may be provided a light emitting diode package (1) including: a light emitting diode chip (100) that generates light of a first color; a wavelength conversion layer (200) disposed above the light emitting diode chip (100), which generates light of a second color by being excited by the light of the first color; a transparent layer (300) disposed above the wavelength conversion layer (200); and a wall portion (400) forming an accommodating space in which the light emitting diode chip (100) and the wavelength conversion layer (200) are accommodated. The wall portion (400) includes an inner surface (401) surrounding the accommodating space, and the transparent layer (300) is connected to the inner surface (401) of the wall portion (400) so that the accommodating space is closed from an outside.

## Description

### TECHNICAL FIELD

The present disclosure relates to a light emitting diode package.

### BACKGROUND ART

A light emitting diode (LED) package emits light to an outside through power received from an external source. Such LED packages are used in lighting, a display backlight, and an automotive headlight, or the like, and are thus exposed to the outside for extended periods of time.

There is a need for an LED package that can maintain reliability over long periods of exposure, by preventing the infiltration of foreign substances, moisture, and other contaminants into the interior of the package, even when exposed to the outside for a long period of time.

### DETAILED DESCRIPTION OF INVENTION

### TECHNICAL PROBLEMS

One embodiment of the present disclosure have been conceived in view of the above, and aims to provide an LED package that prevents foreign substances from infiltrating inside.

### MEANS FOR SOLVING PROBLEMS

In accordance with an aspect of the present disclosure, there may be provided a light emitting diode package (1) including: a light emitting diode chip (100) that generates light of a first color; a wavelength conversion layer (200) disposed above the light emitting diode chip (100), which generates light of a second color by being excited by the light of the first color; a transparent layer (300) disposed above the wavelength conversion layer (200); and a wall portion (400) forming an accommodating space in which the light emitting diode chip (100) and the wavelength conversion layer (200) are accommodated, wherein the wall portion (400) includes an inner surface (401) surrounding the accommodating space, and wherein the transparent layer (300) is connected to the inner surface (401) of the wall portion (400) so that the accommodating space is closed from an outside.

Further, there may be provided the light emitting diode package (1) in which the light emitting diode chip (100) includes: a semiconductor layer (120); and a light transmission substrate (110) disposed above the semiconductor layer (120), and a thickness (t3) of the transparent layer (300) is smaller than a thickness (t1) of the light transmission substrate (110).

Further, there may be provided the light emitting diode package (1) in which the thickness (t1) of the light transmission substrate (110) ranges from 100µm to 150µm.

Further, there may be provided the light emitting diode package (1) in which the thickness (t3) of the transparent layer (300) ranges from 30µm to 50µm.

Further, there may be provided the light emitting diode package (1) in which the light emitting diode chip (100) includes: a semiconductor layer (120); and a light transmission substrate (110) disposed above the semiconductor layer (120), and a thickness (t1) of the light transmission substrate (110) is smaller than a thickness (t2) of the wavelength conversion layer (200).

Further, there may be provided the light emitting diode package (1) in which the thickness (t2) of the wavelength conversion layer (200) ranges from 120µm to 200µm.

Further, there may be provided the light emitting diode package (1) in which the wall portion (400) intersects with an edge extension plane (p), which is an imaginary plane extending in a horizontal direction from a bottom edge (a) of the transparent layer (300).

Further, there may be provided the light emitting diode package (1) in which an upper end of the wall portion (400) includes a sloped surface (410a) that slopes downward toward the outside, and the sloped surface (410a) intersects with the edge extension plane (p) between upper and lower ends thereof.

Further, there may be provided the light emitting diode package (1) in which an upper end of the wall portion (400) includes a sloped surface (410a) that slopes downward toward the outside, the wavelength conversion layer (200) includes a plurality of phosphors (210), and in an up and down direction, the phosphor (210) disposed at the uppermost position among the plurality of phosphors (210) is disposed between upper and lower ends of the sloped surface (410a).

Further, there may be provided the light emitting diode package (1) in which an outer peripheral surface of the wavelength conversion layer (200) and an outer peripheral surface of the transparent layer (300) extend continuously without a notch.

Further, there may be provided the light emitting diode package (1) in which the light emitting diode chip (100) includes: a semiconductor layer (120); and a light transmission substrate (110) disposed above the semiconductor layer (120), and an outer peripheral surface of the wavelength conversion layer (200) and an outer peripheral surface of the transparent layer (300) extend continuously without a notch.

Further, there may be provided the light emitting diode package (1) in which at least a portion of the outer peripheral surface of the light emitting diode chip (100) is spaced apart from the inner surface (401) of the wall portion (400).

Further, there may be provided the light emitting diode package (1) in which the light emitting diode chip (100) includes: a semiconductor layer (120); and a light transmission substrate (110) disposed above the semiconductor layer (120), and a thickness (t1) of the light transmission substrate (110) is greater than a horizontal separation distance between an upper end of an outer peripheral surface of the light transmission substrate (110) and an upper end of the inner surface (401) of the wall portion (400).

Further, there may be provided the light emitting diode package (1) further including; a light transmissive layer (700) that transmits the light of the first color to the wavelength conversion layer (200), the light transmissive layer (700) is disposed between the light emitting diode chip (100) and the wavelength conversion layer (200).

Further, there may be provided the light emitting diode package (1) in which a thickness (t4) of the light transmissive layer (700) is smaller than a thickness (t3) of the transparent layer (300).

Further, there may be provided the light emitting diode package (1) in which the wavelength conversion layer (200) is formed of one or more of PIS (phosphor in silicone), PIG (phosphor in glass), and Si (silicone).

Further, there may be provided a light emitting diode package (1) including: a light emitting diode chip (100) that generates light of a first color; a wavelength conversion layer (200) disposed above the light emitting diode chip (100), which generates light of a second color by being excited by the light of the first color; a wall portion (400) forming an accommodating space in which the light emitting diode chip (100) and the wavelength conversion layer (200) are accommodated; and a transparent layer (300) disposed above the wavelength conversion layer (200) and the wall portion (400) to close the accommodating space from an outside, wherein the wall portion (400) includes an inner surface (401) surrounding the accommodating space, and wherein an outer peripheral surface of the transparent layer (300) is disposed outside the inner surface (401) of the wall portion (400).

Further, there may be provided the light emitting diode package (1) in which the outer peripheral surface of the transparent layer (300) and an outer peripheral surface of the wall portion (400) extend continuously without a notch.

Further, there may be provided the light emitting diode package (1) in which a plurality of protrusions (301a) is formed on a surface (301) of the transparent layer (300) exposed to the outside.

Further, there may be provided a light emitting diode package (1) including: a light emitting diode chip (100) that generates light of a first color; a wavelength conversion layer (200) disposed above the light emitting diode chip (100), which generates light of a second color by being excited by the light of the first color; a wall portion (400) forming an accommodating space in which the light emitting diode chip (100) and the wavelength conversion layer (200) are accommodated; and a transparent layer (300) disposed above the wavelength conversion layer (200) and the wall portion (400) to close the accommodating space from an outside, wherein a surface (301) of the transparent layer (300) has an outwardly convex curved shape.

### EFFECTS OF INVENTION

An LED package according to an embodiment of the present disclosure has the effect of improving reliability by preventing the penetration of foreign substances into its interior.

### BRIEF DESCRIPTION OF DRAWINGS

FIG. 1 is a longitudinal cross-sectional view of a light emitting diode package according to a first embodiment of the present disclosure.
FIG. 2 is a longitudinal cross-sectional view of the light emitting diode package according to the first embodiment of the present disclosure.
FIG. 3 is a longitudinal cross-sectional view of a light emitting diode package according to a second embodiment of the present disclosure.
FIG. 4 is a longitudinal cross-sectional view of a light emitting diode package according to a third embodiment of the present disclosure.
FIG. 5 is a longitudinal cross-sectional view of a light emitting diode package according to a fourth embodiment of the present disclosure.
FIG. 6 is a longitudinal cross-sectional view of a light emitting diode package according to a fifth embodiment of the present disclosure.
FIG. 7 is a longitudinal cross-sectional view of a light emitting diode package according to a sixth embodiment of the present disclosure.
FIG. 8 is a longitudinal cross-sectional view of a light emitting diode package according to a seventh embodiment of the present disclosure.

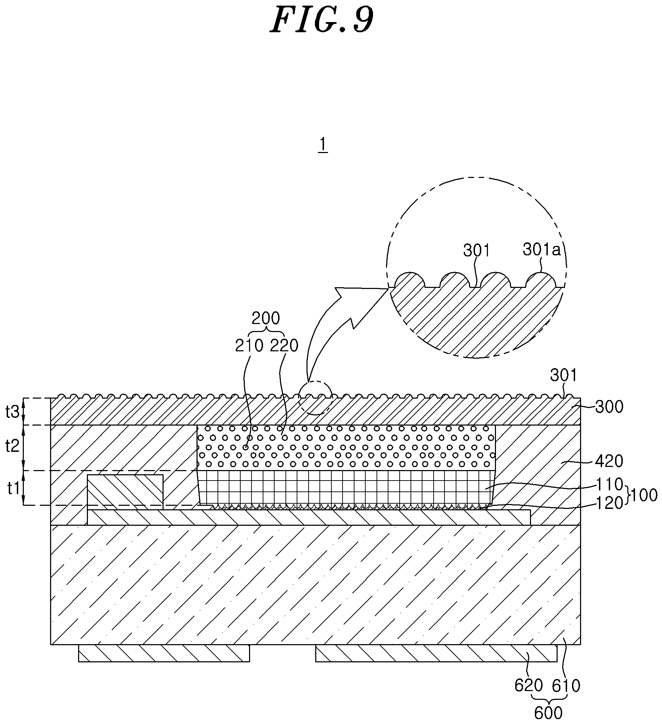

FIG. 9 is a longitudinal cross-sectional view of a light emitting diode package according to an eighth embodiment of the present disclosure.
FIG. 10 is a longitudinal cross-sectional view of a light emitting diode package according to a ninth embodiment of the present disclosure.
FIG. 11 is an illustration of a tenth embodiment of the present disclosure, showing that the light emitting device is installed in an automotive lamp.
FIG. 12 is a longitudinal cross-sectional view of an eleventh embodiment of the present disclosure, illustrating a plurality of light emitting devices installed.
FIG. 13 is a longitudinal cross-sectional view of a twelfth embodiment of the present disclosure, illustrating a plurality of light emitting devices installed.

### MODE FOR CARRYING OUT THE INVENTION

Hereinafter, specific embodiments for implementing a spirit of the present disclosure will be described in detail with reference to the drawings.

In describing the present disclosure, detailed descriptions of known configurations or functions may be omitted to clarify the present disclosure.

When an element is referred to as being 'connected' to, or 'stacked' on another element, it should be understood that the element may be directly connected to, or stacked on another element, but that other elements may exist in the middle.

The terms used in the present disclosure are only used for describing specific embodiments, and are not intended to limit the present disclosure. Singular expressions include plural expressions unless the context clearly indicates otherwise.

Further, terms including ordinal numbers, such as first and second, may be used for describing various elements, but the corresponding elements are not limited by these terms. These terms are only used for the purpose of distinguishing one element from another element.

In the present specification, it is to be understood that the terms such as "including" are intended to indicate the existence of the certain features, areas, integers, steps, actions, elements, combinations, and/or groups thereof disclosed in the specification, and are not intended to preclude the possibility that one or more other certain features, areas, integers, steps, actions, elements, combinations, and/or groups thereof may exist or may be added.

In the present disclosure, it is to be noted that expressions, such as the upper portion, the lower portion, and the upper surface are described based on the illustration of drawings, but may be modified if directions of corresponding objects are changed. Further, the up and down direction can be defined as the direction in which a light emitting diode chip 100, a wavelength conversion layer 200, and a transparent layer 300 are stacked. Furthermore, an upward direction may be defined as the direction in which the wavelength conversion layer 200 faces the transparent layer 300, and the downward direction may be defined as the opposite direction of the upward direction.

Hereinafter, a specific configuration of a light emitting diode package 1 according to a first embodiment of the present disclosure will be described with reference to drawings.

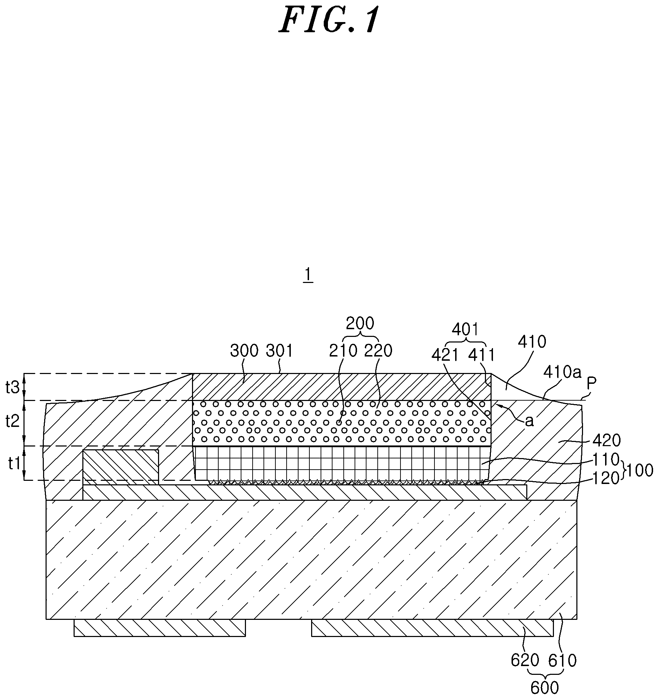

Referring to FIG. 1, the light emitting diode package according to the first embodiment of the present disclosure may receive power from an outside and emit light externally. This light emitting diode package may include a light emitting diode chip 100, a wavelength conversion layer 200, a transparent layer 300, a wall portion 400, and a substrate 600.

The light emitting diode chip 100 may be electrically connected to the substrate 600. The light emitting diode chip 100 may generate light of a first color. The light of the first color, for example, may have a peak wavelength in the range of 430nm to 550nm. The light emitting diode chip 100 may be mounted on the substrate 600.

The light emitting diode chip 100 may include a light transmission substrate 110 and a semiconductor layer 120. The semiconductor layer 120 is formed on the light transmission substrate 110 and may be in contact with the light transmission substrate 110. The light transmission substrate 110 may be positioned between the semiconductor layer 120 and the wavelength conversion layer 200 in an up and down direction. For example, the light transmission substrate 110 may be disposed upward of the semiconductor layer 120 and downward of the wavelength conversion layer 200.

The material of the light transmission substrate 110 may include, for example, one or more of sapphire (Al₂O₃), silicon carbide (SiC), gallium nitride (GaN), indium gallium nitride (InGaN), aluminum gallium nitride (AlGaN), aluminum nitride (AlN), gallium oxide (Ga₂O₃), and silicon. The thickness t1 of the light transmission substrate 110, for example, may be in the range of 100µm to 150µm. The thickness t1 of the light transmission substrate 110 is defined as the vertical separation distance between the upper end and the lower end of the light transmission substrate 110. A light generated in the semiconductor layer 120 will spread evenly across both horizontal and vertical areas within the light transmission substrate 110, and the uniformly distributed light will pass through the light transmission substrate 110 and then be incident on the wavelength conversion layer 200. If the thickness t1 of the light transmission substrate 110 is less than 100µm, the light may not sufficiently diffuse within the light transmission substrate 110, resulting in uneven light incidence on the wavelength conversion layer 200 and a decrease in the optical conversion efficiency of the wavelength conversion layer 200. Therefore, increasing the thickness t1 of the light transmission substrate 110 to more than 100µm will allow the uniformly distributed light within the light transmission substrate 110 to enter the wavelength conversion layer 200, maximizing the optical conversion efficiency.

However, if the thickness t1 of the light transmission substrate 110 exceeds 150µm, the diffusion path of the light will be extended, and there is a higher likelihood that the light will be lost. Additionally, if the thickness t1 of the light transmission substrate 110 exceeds 150µm, the heat generated by the light emitting diode chip 100 may accumulate in the light transmission substrate 110, and the accumulated heat could heat the wavelength conversion layer 200, potentially damaging the wavelength conversion layer 200.

Thus, by keeping the thickness t1 of the light transmission substrate 110 below 150µm, the light extraction efficiency from the light emitting diode chip 100 can be improved. Additionally, by keeping the thickness t1 of the light transmission substrate 110 below 150µm, the accumulation of heat generated by the light emitting diode chip 100 can be prevented, thereby protecting the wavelength conversion layer 200 from damage. The light transmission substrate 110 may have a sapphire outer peripheral surface 111 and a patterned bottom surface 112.

The outer peripheral surface 111 of the light transmission substrate 110 can be defined as the outer circumferential surface of the light transmission substrate 110. The peripheral surface 111 may include a side surface that is perpendicular to a top surface of the light transmission substrate 110, which faces the wavelength conversion layer 200, or may include a side surface that is inclined at a predetermined angle (0° to 30°). The outer peripheral surface 111 of the light transmission substrate 110 may be surrounded by the wall portion 400. For example, some portion of the sapphire outer peripheral surface 111 may be adjacent to or in contact with the wall portion 400. Alternatively, in another form, some portion of the sapphire outer peripheral surface 111 may be in contact with the wall portion 400, while another portion may be spaced apart from the wall portion 400.

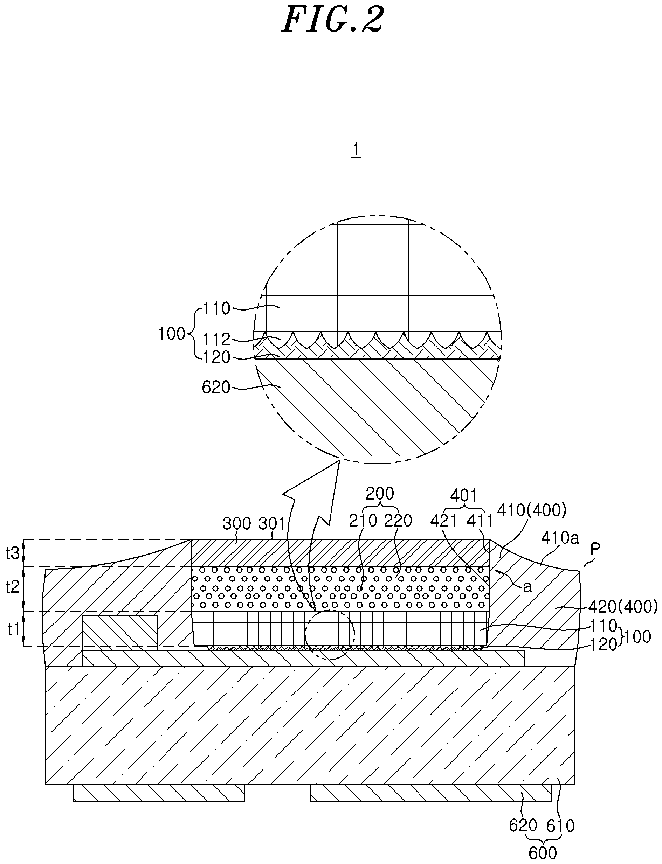

Referring further to FIG. 2, the patterned bottom surface 112 may be defined as a bottom surface of the light transmission substrate 110. A predetermined pattern may be formed on the patterned bottom surface 112. For example, a plurality of grooves or projections may be formed on the patterned bottom surface 112. The plurality of grooves or projections formed on the patterned bottom surface 112 may be arranged along a horizontal direction. The patterned bottom surface 112 may be connected to the top surface of the semiconductor layer 120. The light transmission substrate 110 with the patterned bottom surface 112 may be referred to as a PSS (Patterned Sapphire Substrate).

The semiconductor layer 120 may include an n-type semiconductor layer and a p-type semiconductor layer. The n-type semiconductor layer may be a gallium nitride-based (e.g., AlGaN or GaN) semiconductor layer doped with silicon (Si). The p-type semiconductor layer may be a gallium nitride-based (e.g., AlGaN or GaN) semiconductor layer doped with magnesium (Mg). The semiconductor layer 120 may be formed as one or more of a single layer, multiple layers, or a superlattice structure. The semiconductor layer 120 may further include an active layer that can generate light. The active layer may have a single quantum well (SQW) structure or a multiple quantum well (MQW) structure. The composition and thickness of the well layers in the active layer determine the wavelength of the generated light. The semiconductor layer may include materials such as AlₓIn₍₁₋ₓ₎GaN (0≤x≤1) or AlₓIn₍₁₋ₓ₎GaP (0 ≤x≤ 1) or AlₓIn₍₁₋ₓ₎GaAs (0≤x≤1).

The wavelength conversion layer 200 may convert the wavelength of light of a first color to generate light of a second color. The wavelength conversion layer 200 may be referred to as "wavelength conversion layer" in the present specification. The light of the second color, for example, may have a peak wavelength in the wavelength range of 470nm to 550nm. Alternatively, it could be cyan light with CIE coordinates (X, Y) (0.02 < X < 0.24, 0.32 < Y < 0.68). The wavelength conversion layer 200 may be positioned on the light emitting diode chip 100. For example, the wavelength conversion layer 200 may be positioned above the light emitting diode chip 100. Moreover, the thickness t2 of the wavelength conversion layer 200 may be greater than the thickness t1 of the light transmission substrate 110. The thickness t2 of the wavelength conversion layer 200 is defined as the vertical separation distance between the upper end and the lower end of the wavelength conversion layer 200. The thickness t2 of the wavelength conversion layer 200, for example, may be in the range of 120µm to 200µm. If the thickness t2 of the wavelength conversion layer 200 is less than 120µm, there is a problem that it becomes difficult to achieve the concentration ratio formed within a certain volume of a matrix 220, which is composed of phosphor 210 or the absorbent material (not shown), as will be discussed later. For example, for generating light of the second color, a certain amount or more of the phosphor 210 is required. However, if the thickness t2 of the wavelength conversion layer 200 is less than 120µm, it becomes difficult to both achieve the predetermined concentration ratio and include the required amount of the phosphor 210 for wavelength conversion. In other words, if the thickness t2 of the wavelength conversion layer 200 is greater than 120µm, a predetermined concentration ratio can be achieved while ensuring that a sufficient amount of the phosphor 210 is included.

On the other hand, if the thickness t2 of the wavelength conversion layer 200 exceeds 200µm, the amount of light absorbed inside the wavelength conversion layer 200 increases, which may result in a decrease in the optical efficiency of the light emitting diode package 1. In other words, if the thickness t2 of the wavelength conversion layer 200 is less than 200µm, the amount of light absorbed inside the wavelength conversion layer 200 can be minimized, preventing a decrease in the optical efficiency of the light emitting diode package 1.

The material of the wavelength conversion layer 200 may include one or more of PIS (phosphor in silicone), PIG (phosphor in glass), and Si (silicone). The wavelength conversion layer 200 may include the phosphor 210, an absorbing material, the matrix 220, and a reinforcing material (not shown).

The phosphor 210 can excite light of the first color to generate cyan light as the second color. The phosphor 210 may be provided in a plurality. The plurality of phosphors 210 may be irregularly distributed within the matrix 220. Among the plurality of phosphors 210, the one closest to the transparent layer 300 may be positioned between upper and lower ends of a sloped surface 410a, which will be described later. In other words, the phosphor 210 located at the topmost position among the plurality of phosphors 210 may be positioned above the lower end of the sloped surface 410a. The plurality of phosphors 210 may be arranged in different regions within the matrix 220, and may include both a first phosphor and a second phosphor with different compositions.

The first phosphor may be a phosphor of the LuAG series. For example, the first phosphor may emit light with a peak wavelength in the range of 490nm to 550nm. The second phosphor may be a phosphor of the silicate series. The second phosphor may emit light with a peak wavelength in the range of 400nm to 600nm. However, the spirit of the present invention is not limited thereto, the phosphor 210 may further include other series of phosphors in addition to LuAG series and silicate series phosphors.

The absorbing material can absorb light in a predetermined wavelength range of the spectrum of the phosphor 210. For example, the wavelength range of the spectrum of the phosphor 210 may be equal to or below 550nm. The absorbing material may be mixed with the phosphor 210 and dispersed in the matrix 220. The absorbing material converts the phosphor 210 to have a shorter wavelength and can enhance the color purity of the cyan light. The absorbing material may, for example, include neodymium oxide. Furthermore, the ratio of the first phosphor, the second phosphor, and the absorbing material to the first phosphor may be, for example, 70% to 80%.

The matrix 220 may hold the first phosphor, the second phosphor, and the absorbing material. This matrix 220 may be a transparent or translucent material. The matrix 220 may include, for example, at least one of silicone series, epoxy series, polymethyl methacrylate (PMMA) series, polyethylene (PE) series, and polystyrene (PS) series.

The reinforcing material can improve the heat resistance and durability of the wavelength conversion layer 200. The reinforcing material may be contained in the matrix 220. The reinforcing material may, for example, be glass fiber. Additionally, the reinforcing material may be referred to as a "reinforcing filler". It helps prevent the emission of unconverted light through cracks that may occur due to the heat generated by the light emitting diode chip and package.

The transparent layer 300 may seal an accommodating space accommodating the light emitting diode chip 100 and the wavelength conversion layer 200 from the outside of the light emitting diode package 1. In other words, the transparent layer 300 can prevent foreign substances and moisture from penetrating into the accommodating space accommodating the light emitting diode chip 100 and wavelength conversion layer 200. Further, the transparent layer 300 serves to diffuse the light that has been converted in the wavelength conversion layer 200 before it is emitted externally, and to emit the light that is evenly distributed.

The transparent layer 300 may include a transparent material. The transparent layer 300 may be laminated on an upper surface of the wavelength conversion layer 200. In other words, the transparent layer 300 may be disposed above the wavelength conversion layer 200. The thickness t3 of the transparent layer 300 may be smaller than the thickness t2 of the light emitting diode chip 100 and the wavelength conversion layer 200. The thickness t3 of the transparent layer 300 is defined as the vertical separation distance between the upper end and the lower end of the transparent layer 300. The thickness t3 of the transparent layer 300 may, for example, be in the range of 30µm to 50µm. If the thickness t3 of the transparent layer 300 is less than 30µm, the likelihood of foreign substances or moisture penetrating into the accommodating space increases, leading to reduced reliability of the light emitting diode package 1. In other words, if the thickness t3 of the transparent layer 300 is greater than 30µm, it can block the penetration of foreign substances and moisture into the accommodating space, thus improving the reliability of the light emitting diode package 1. Further, sufficient space is needed in the transparent layer 300 for the light that passes through the wavelength conversion layer 200 to be evenly diffused, however, when the thickness t3 of the transparent layer 300 is less than 30µm, the diffusion will be insufficient, resulting in the problem that light intensity is relatively high in areas where the phosphor 210 of the wavelength conversion layer 200 is concentrated. In other words, if the thickness t3 of the transparent layer 300 is greater than 30µm, even if the intensity of light entering the transparent layer 300 is uneven, the light can be uniformly diffused in the transparent layer 300, thereby resolving the problem of light intensity imbalance in the package's light emission surface.

Furthermore, if the thickness t3 of the transparent layer 300 exceeds 50µm, a height of the wall portion 400 increases, which may prevent miniaturization of the light emitting diode package 1. For example, the height of the wall portion 400 is provided to correspond to the height of the transparent layer 300, and thus, the height of the wall portion 400 may be determined by the height of the transparent layer 300. Further, if the thickness t3 of the transparent layer 300 exceeds 50µm, the amount of light of the second color absorbed by the transparent layer 300 increases, resulting in decreased optical efficiency of the light emitting diode package 1. In other words, if the thickness t3 of the transparent layer 300 is less than 50µm, the amount of light of the second color absorbed by the transparent layer 300 can be minimized, thereby preventing a decrease in optical efficiency of the light emitting diode package 1.

Moreover, if the thickness t3 of the transparent layer 300 exceeds 50µm, the diffusion path of the light within the transparent layer 300 becomes longer during the diffusion process, which increases the possibility of light loss. Therefore, by setting the thickness of the transparent layer 300 in the range of 30µm to 50µm, an optimized light emitting diode package with balanced light intensity and optimal optical efficiency can be achieved.

The transparent layer 300 may have an edge "a" formed at its bottom. The edge "a" can be defined as the edge of the interface between the transparent layer 300 and the wavelength conversion layer 200. The edge "a" may be positioned between the upper and lower ends of the sloped surface 410a. For example, the horizontal extension "p" of the edge "a" may intersect with the sloped surface 410a. The horizontal extension "p" of the edge "a" can be defined as a virtual line extending horizontally along the interface between the transparent layer 300 and the wavelength conversion layer 200, which is perpendicular to the up and down direction. If the distinction between the transparent layer 300 and the wavelength conversion layer 200 is unclear, the horizontal extension "p" can be defined as a virtual line extending parallel to the light transmission substrate 110 from the topmost of the phosphor 210. If the horizontal extension "p" is arranged to intersect with the sloped surface 410a, the thickness of the sidewall 400 on the side of the wavelength conversion layer 200 will not be uniform. In other words, the sidewall 400 disposed on the side of the upper region of the wavelength conversion layer 200 will have a thinner thickness in the horizontal direction compared to the sidewall 400 disposed on the side of the lower region of the wavelength conversion layer 200. This arrangement facilitates heat emission from the area closer to the light emission surface, helping to prevent degradation of the phosphor 210 placed near the light emission surface. By preventing degradation of the phosphor 210, it becomes possible to prevent the emission of light with wavelengths other than the intended ones from the phosphor 210.

The transparent layer 300 may include reinforcing material. The reinforcing material may be the same material as the one included in the wavelength conversion layer 200 but in a different form. Since the shapes may differ, the reinforcing force and bonding strength can vary, leading to a broader range of reinforcing and bonding capabilities, effectively enhancing the protective function of the transparent layer.

The wall portion 400 may be arranged to surround the light emitting diode chip 100, the wavelength conversion layer 200, and the transparent layer 300. The wall portion 400 may provide the accommodating space where the light emitting diode chip 100, the wavelength conversion layer 200, and the transparent layer 300 can be accommodated. The wall portion 400 may include a reflective material, reflecting light emitted from the side of the light emitting diode chip 100 upwards, thereby increasing light efficiency. The wall portion 400 may have an inner surface 401 that forms the accommodating space. The inner surface 401 may reflect the light generated in the wavelength conversion layer 200. For example, the inner surface 401 may include materials that reflect light. The wall portion 400 may include a sloped wall section 410 and a body wall section 420.

The sloped wall section 410 may have a sloped surface 410a that tilts downward at the upper end portion thereof. The sloped surface 410a may have a shape that decreases in height as it moves from the inner side to the outer side. In other words, an upper end of the sloped surface 410a may be positioned inward of a lower end of the sloped surface 410a. The sloped surface 410a may also have a downwardly concave curvature. The sloped wall section 410 may have a sloped wall inner surface 411 surrounding the transparent layer 300.

The sloped wall inner surface 411 may be defined as the inner circumferential surface of the sloped wall section 410. The sloped wall inner surface 411 may be connected to the transparent layer 300. For example, the sloped wall inner surface 411 may be in contact with an outer circumference of the transparent layer 300. The lower end of the sloped wall inner surface 411 may be positioned lower than the upper end of the wavelength conversion layer 200. In other words, the lower end of the sloped wall inner surface 411 may be disposed lower than the topmost phosphor 210 among the plurality of phosphors 210. The sloped wall inner surface 411 may be included in the inner surface 401.

The body wall section 420 may be positioned between the sloped wall section 410 and the substrate 600. The body wall section 420 may extend in the up and down direction between the lower end of the sloped wall section 410 and the upper surface of the substrate 600. The body wall section 420 may have a body wall inner surface 421 that surrounds the light emitting diode chip 100 and the wavelength conversion layer 200. The thickness of the body wall section 420 in the up and down direction will be greater than that of the light emitting diode chip 100. The upper surface of the body wall section 420 may be positioned higher than the upper surface of the light emitting diode chip 100.

The body wall section 420 prevents light emitted from the light emitting diode chip 100 from leaking out while also having light-reflecting properties that reflect the light emitted from the light emitting diode chip 100 upwards. The outer surface of the body wall section 420 may be aligned with the outer surface of the base 610 located at the lower end of the body wall section 420. If the outer surface of the body wall section 420 protrudes beyond the base 610, damage to the body wall section 420 may occur due to external impact, causing light leakage and resulting in light loss. To prevent this, it is effective to align the outer surfaces of the base 610 and the body wall section 420. When viewed from a side cross-section, the body wall sections 420 arranged on the left and right of the light emitting diode chip 100 may have different thicknesses from the surface where the light emitting diode chip 100 and the body wall section 420 face each other to the outer surface of the body wall section 420.

The upper portion of the body wall inner surface 421 may be arranged to surround the wavelength conversion layer 200. The upper portion of the body wall inner surface 421 may contact the outer circumferential surface of the wavelength conversion layer 200. Additionally, the lower portion of the body wall inner surface 421 may be arranged to surround the light transmission substrate 110. The lower portion of the body wall inner surface 421 may be spaced horizontally from the light transmission substrate 110. The body wall inner surface 421 may be formed to incline outward. For example, the upper end of the lower portion of the body wall inner surface 421 may be positioned outward of the lower end thereof.

The substrate 600 may be electrically connected to the light emitting diode chip 100. This substrate 600 may mount the light emitting diode chip 100. The substrate 600 can support the light emitting diode chip 100, the wavelength conversion layer 200, the transparent layer 300, and the wall portion 400. The substrate 600 may include a base 610 and an electrode pad 620.

The base 610 may be connected to the electrode pad 620 and the wall portion 400. The base 610 may be disposed below the accommodating space. The upper surface of the base 610 may extend horizontally to form the bottom surface of the substrate 600.

The electrode pad 620 may receive power from the outside. The electrode pad 620 may be electrically connected to the light emitting diode chip 100. The upper surface of the electrode pad 620 may contact the lower surface of the light emitting diode chip 100. The upper surface of the electrode pad 620 may be positioned above the upper surface of the base 610. Additionally, the lower surface of the electrode pad 620 may be positioned below the lower surface of the base 610. At least a part of the electrode pad 620 may be positioned inside the base 610.

Hereinafter, the operation and effects of the light emitting diode package 1 according to the first embodiment of the present disclosure are described.

The light emitting diode package 1 can generate light of a first color from the light emitting diode chip 100 using the current supplied from the outside. Some of the light of the first color may be directed toward the wavelength conversion layer 200, while the rest may move toward the gap. Some of the light of the first color may be reflected from the lower portion of the body wall inner surface 421. For example, the light path of the reflected light of the first color may be directed upwards due to the slope formed at the lower portion of the body wall inner surface 421. Thus, by increasing the amount of the light of the first color directed toward the wavelength conversion layer 200 through the slope formed at the lower portion of the body wall inner surface 421, the light efficiency is improved.

The light of the first color can reach the wavelength conversion layer 200. The light of the first color reaching the wavelength conversion layer 200 can be excited by a mixture of the first phosphor, the second phosphor, and the absorbent material, and can be converted into light of the second color (cyan). The light of the second color may pass through the transparent layer 300 and be emitted outside the light emitting diode package 1.

The light emitting diode package 1 has the effect of preventing foreign substances or moisture from penetrating into the accommodating space where the light emitting diode chip 100 and the wavelength conversion layer 200 are placed, because the transparent layer 300 seals the accommodating space from the outside.

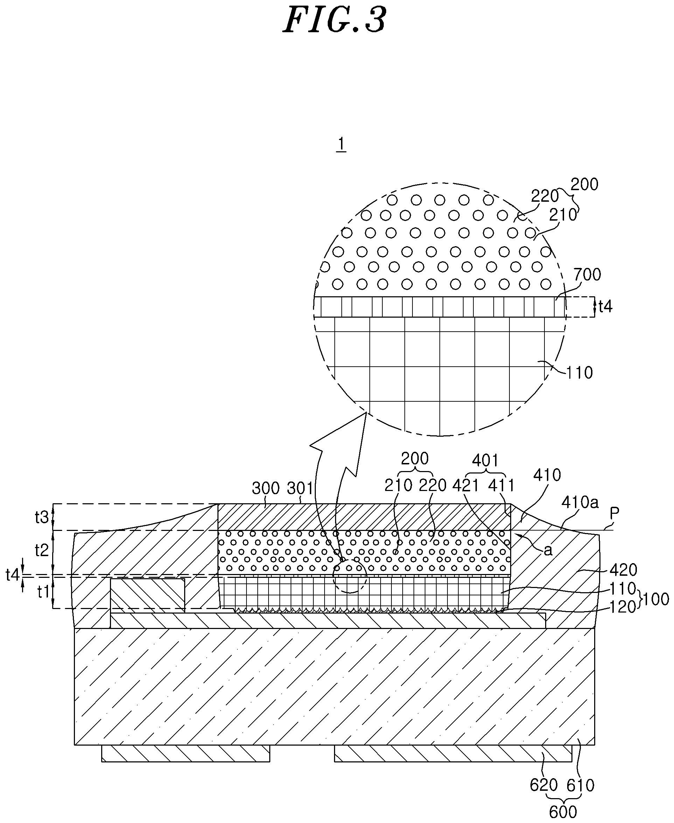

Meanwhile, in addition to the above configuration, according to a second embodiment of the present disclosure, a light transmissive layer 700 may further be included. Hereinafter, with reference to FIG. 3, the second embodiment of the present disclosure will be described. In describing the second embodiment, the focus will be on the differences compared to the previously described embodiment, and the same descriptions and reference numerals will refer to the previously described embodiment.

The light transmissive layer 700 may allow light of the first color generated by the light emitting diode chip 100 to pass through to the wavelength conversion layer 200. The light transmissive layer 700 may be disposed between the light emitting diode chip 100 and the wavelength conversion layer 200 in the up and down direction. For example, the upper surface of the light transmissive layer 700 may be connected to the lower surface of the wavelength conversion layer 200, and the lower surface of the light transmissive layer 700 may be connected to the upper surface of the light emitting diode chip 100. In other words, the light transmissive layer 700 may serve to bond the light emitting diode chip 100 and the wavelength conversion layer 200 together. The light transmissive layer 700 may be referred to as an "adhesive layer." Additionally, the thickness t4 of the light transmissive layer 700 may be thinner than the thickness t3 of the transparent layer 300. The thickness t4 of the light transmissive layer 700 may be defined as the vertical separation distance between the upper end and the lower end of the light transmissive layer 700.

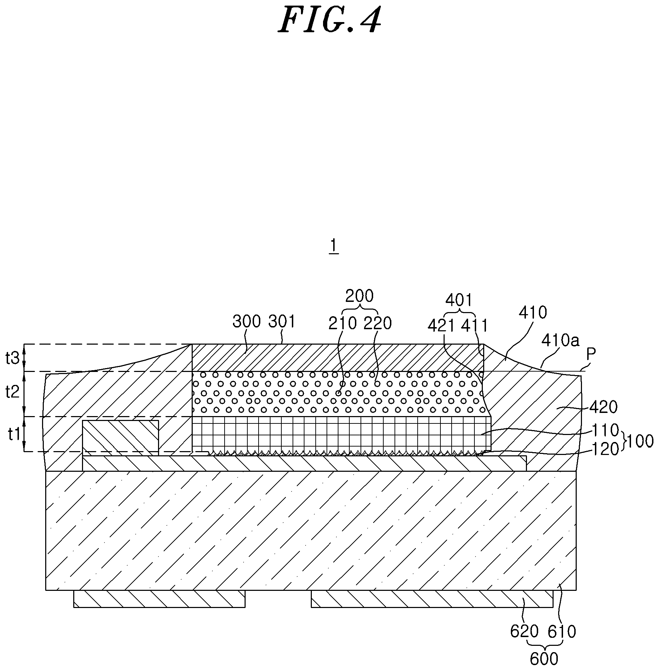

Meanwhile, in addition to the above configuration, according to a third embodiment of the present invention, the outer peripheral surface of the wavelength conversion layer 200 and the outer peripheral surface of the transparent layer 300 may be oriented such that they are not parallel to each other. Hereinafter, with reference to FIG. 4, the third embodiment of the present invention will be described. In describing the third embodiment, the focus will be on the differences compared to the previously described embodiments, and the same descriptions and reference numerals will refer to the previously described embodiments.

The outer peripheral surface of the wavelength conversion layer 200 and the outer peripheral surface of the transparent layer 300 may extend non-linearly along the up and down direction. For example, the outer peripheral surface of the wavelength conversion layer 200 and the outer peripheral surface of the transparent layer 300 may form a notch at the point where they meet and have a continuously extending shape.

Furthermore, when the uppermost surface of the wavelength conversion layer 200 is projected in the up and down direction onto the uppermost surface of the transparent layer 300, the outer peripheral surface of the wavelength conversion layer 200 and the outer peripheral surface of the transparent layer 300 may partially overlap, while other portions may not overlap. Further, when viewing the light emitting diode chip 100 in the horizontal direction, the width of the wavelength conversion layer 200 in the horizontal direction and the width of the transparent layer 300 in the horizontal direction may be different from each other.

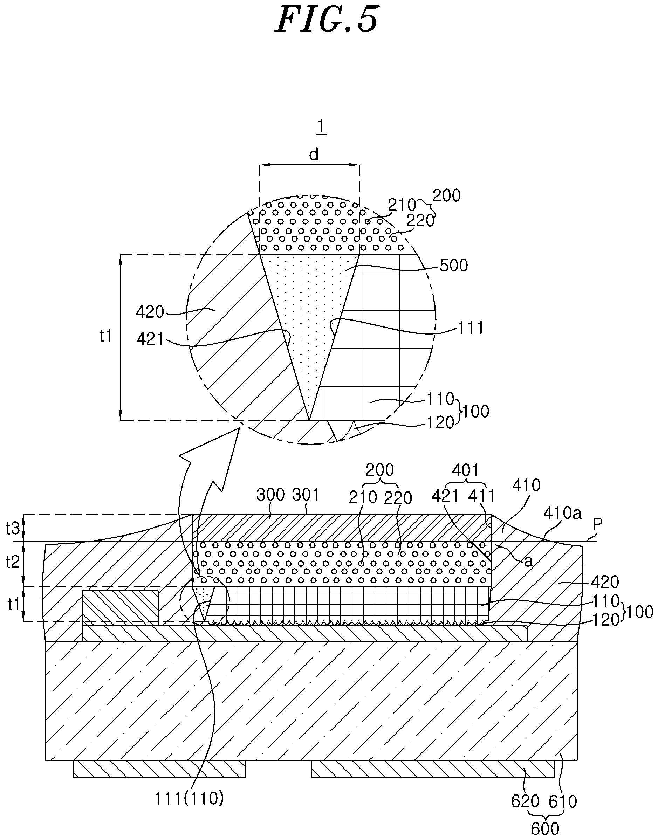

Meanwhile, in addition to the above configuration, according to a fourth embodiment of the disclosure, a predetermined gap may be formed between the lower portion of the body wall inner surface 421 and the light transmission substrate 110, and a bonding member 500 may be disposed in the gap. Hereinafter, the fourth embodiment will be described with reference to FIG. 5. In describing the fourth embodiment, the differences compared to the previously described embodiments will be mainly explained, and the same descriptions and reference numerals refer to the embodiments described above.

The gap between the lower portion of the body wall inner surface 421 and the light transmission substrate 110 may have a shape where the width in the horizontal direction increases as it moves upward. The width of the gap may be defined as the separation distance between the outer peripheral surface of the light transmission substrate 110 and the lower portion of the body wall inner surface 421. The width "d" at the upper end of the gap may be smaller than the thickness t1 of the light transmission substrate 110.

The bonding member 500 may be placed in the gap and supported by the substrate 600. For example, the bonding member 500 may be filled in the gap between the lower portion of the body wall inner surface 421 and the light transmission substrate 110. The bonding member 500 may come into contact with the lower portion of the body wall inner surface 421, the outer peripheral surface of the light transmission substrate 110, and the wavelength conversion layer 200. As one example, the bonding member 500 may be made of a transparent material such as silicon.

Further, the bonding member 500 may, for example, be made of the same material as the matrix 220. In other words, the bonding member 500 may include at least one of the following: silicone-based, epoxy-based, PMMA (polymethyl methacrylate)-based, PE (polyethylene)-based, or PS (polystyrene)-based materials. Additionally, in the bonding member 500, the phosphor 210 is not be included.

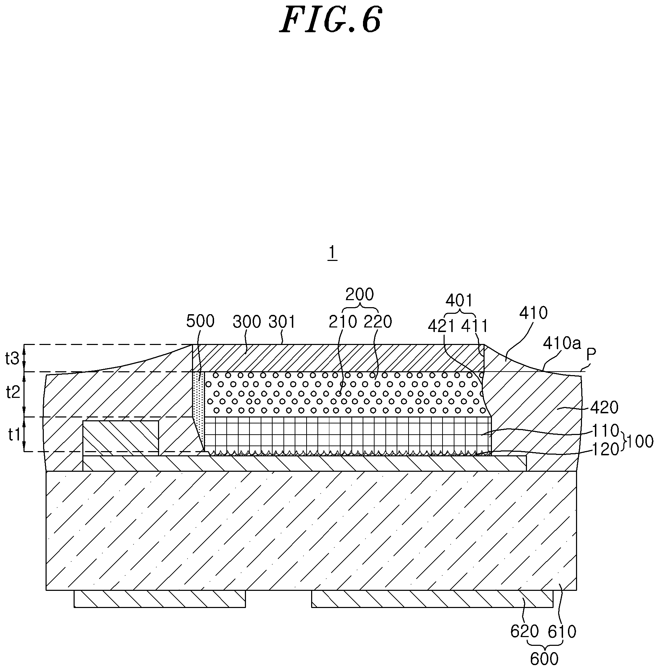

Meanwhile, in addition to the above configuration, according to a fifth embodiment of the present disclosure, the outer peripheral surface of the light transmission substrate 110 and the outer peripheral surface of the wavelength conversion layer 200 may be oriented parallel to each other. The fifth embodiment of the present disclosure will be described below with reference to FIG. 6. In describing the fifth embodiment, the differences compared to the previously described embodiments will be mainly explained, and the same descriptions and reference numerals refer to the embodiments described above.

The outer peripheral surface of the light transmission substrate 110 and the outer peripheral surface of the wavelength conversion layer 200 may extend continuously in the up and down direction. For example, the outer peripheral surfaces of the light transmission substrate 110 and the wavelength conversion layer 200 may form a continuous shape without any notches.

Furthermore, when the light transmission substrate 110 and the wavelength conversion layer 200 are projected onto each other in the up and down direction, the outer peripheral surfaces of the light transmission substrate 110 and the wavelength conversion layer 200 may overlap each other. Further, when the light emitting diode package 1 is viewed horizontally, the horizontal width of the light transmission substrate 110 and the horizontal width of the wavelength conversion layer 200 may be the same.

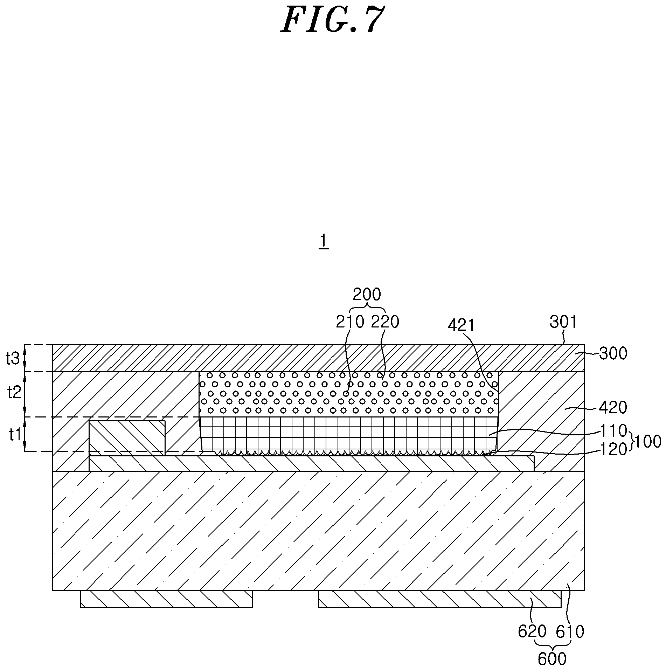

In addition to this configuration, according to a sixth embodiment of the present disclosure, the transparent layer 300 may be stacked on the wavelength conversion layer 200 and the wall portion 400. Hereinafter, a sixth embodiment of the present disclosure will be described with reference to FIG. 7. In describing the sixth embodiment, the differences compared to the previously described embodiments will be mainly explained, and the same descriptions and reference numerals refer to the embodiments described above.

The transparent layer 300 may be stacked on the wavelength conversion layer 200 and the wall portion 400. For example, the transparent layer 300 may extend horizontally and connect to the upper surface of the wall portion 400. The transparent layer 300 may have a shape that covers the upper surfaces of the wavelength conversion layer 200 and the wall portion 400.

Further, the outer peripheral surface of the transparent layer 300 may be aligned parallel to the outer peripheral surface of the wall portion 400. The outer circumferential surface of the transparent layer 300 may extend continuously in the up and down direction of the wall portion 400. For example, the outer peripheral surfaces of the transparent layer 300 and the wall portion 400 may form a continuous shape without any notches.

Furthermore, when the transparent layer 300 and the wall portion 400 are projected onto each other in the up and down direction, the outer circumferential surfaces of the transparent layer 300 and the wall portion 400 may overlap each other. Also, when the light emitting diode package 1 is viewed horizontally, the horizontal width of the transparent layer 300 and the horizontal width of the wall portion 400 may be the same.

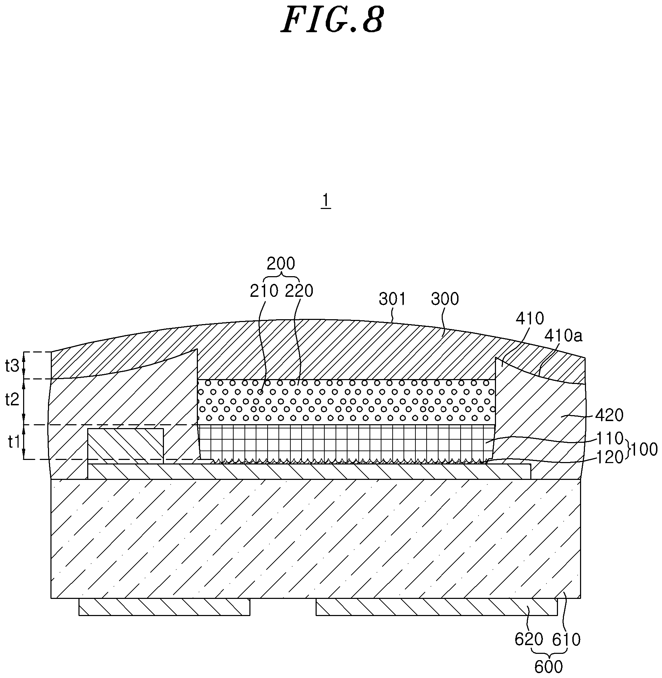

Meanwhile, in addition to the above configuration, according to a seventh embodiment of the present disclosure, a protrusion 301a may be formed on the surface 301 of the transparent layer 300. Hereinafter, the seventh embodiment of the present disclosure will be described with reference to FIG. 8. In describing the seventh embodiment, the differences compared to the embodiments described above will be mainly explained, and the same descriptions and reference numerals refer to the embodiments described above.

The surface 301 of the transparent layer 300 may be defined as the upper surface of the transparent layer 300. The surface 301 of the transparent layer 300 may be exposed to the outside of the light emitting diode package 1. The protrusion 301a formed on the surface 301 of the transparent layer 300 may be arranged in the horizontal direction. Through the protrusion 301a, the total internal reflection of light of the second color on the surface 301 of the transparent layer 300 can be minimized. In this way, the protrusion 301a maximizes the light extraction efficiency of the light emitting diode package 1.

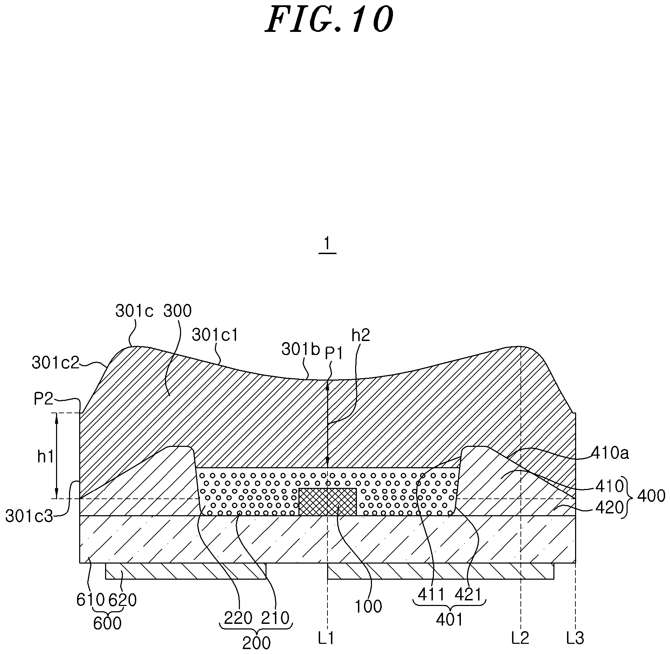

Meanwhile, in addition to the above configuration, according to a ninth embodiment of the present disclosure, a portion of the upper surface of the transparent layer 300 of the light emitting diode package 1 may have a structure that is recessed in the direction of the light emitting diode chip 100. Hereinafter, with further reference to FIG. 10, the ninth embodiment of the present disclosure will be described. In describing the ninth embodiment, the differences compared to the embodiments described above will be mainly explained, and the same descriptions and reference numerals refer to the embodiments described above.

Referring to FIG. 10, the structure of the transparent layer 300, where a portion of the upper surface is recessed in the direction of the light emitting diode chip 100, improves light extraction and increases the outer surface area of the transparent layer, thereby lengthening the diffusion path.

One or more of a convex portion 301c and a concave portion 301b may be formed at the upper portion of the transparent layer 300.

The convex portion 301c of the transparent layer 300 is formed as a curved surface that protrudes upward from the edge of the upper portion of the transparent layer 300, which helps to disperse external impacts and stresses, thereby preventing breakage. Additionally, since the convex portion 301c is positioned to overlap with the wall portion 400 in the up and down direction, the thickness of the transparent layer 300 increases at the upper portion of the wall portion 400, thereby preventing moisture permeation.

The curvature at the upper portion of the convex portion 301c may be smaller than the curvature of the concave portion 301b which is the recessed portion of the transparent layer 300. Additionally, the convex portion 301c may be positioned adjacent to the edge of the light emitting diode package 1 and may be spaced apart from the center axis L1. The distance between the central axis L1 and the line L2 passing through the vertex of convex portion 301c and parallel to the central axis L1 is greater than half the distance between the central axis L1 and the outer side surface L3 disposed at the edge of the substrate 600, but smaller than the distance between the central axis L1 and the outer side surface L3 of the substrate 600.

The width of the transparent layer 300 may gradually decrease as it moves upward from a position parallel to the concave portion 301b to the vertex of the convex portion 301c. As the width of the transparent layer 300 decreases, the variation in light sensitivity and color difference between the center and the periphery per unit area of the light emitting diode package 1 can be reduced. In other words, the slope of the outer surface of the transparent layer 300 from the concave portion 301b to the convex portion 301c may be gentler than the slope of the sloped wall inner surface 411. Therefore, side light extraction from the light emitting diode package 1 may be advantageous.

The transparent layer 300 may include a first surface 301c1 that extends from an inclined surface on the upper edge side thereof and the convex portion 301c to the concave portion 301b and a second surface 301c2 which is the outer surface of the substrate (the outermost edge surface), and the first surface 301c1 and the second surface 301c2 may have different inclinations. The outer surface 301c2 of the substrate may extend in the up and down direction. On the other hand, the transparent layer 300 may further include a third surface 301c3 that is parallel to the substrate. The inclination of the second surface 301c2 may be greater than that of the first surface 301c1 and smaller than that of the third surface 301c3.

The inclination of the second surface 301c2 of the convex portion 301c may be formed more steeply than the inclination of the sloped surface 410a of the wall portion 400. Therefore, the sloped surface 410a of the wall portion 400 guides the light emitted from the light emitting diode chip 100 toward the second surface 301c2 of the convex portion 301c, which helps reduce the light intensity difference between the convex portion 301c and the concave portion 301b of the transparent layer 300.

The thickness h1 of the third surface 301c3 of the transparent layer 300 may be greater than the distance h2 from the center point P1 of the concave portion 301b to the wavelength conversion layer 200. The point P2 where the third surface 301c3 and the second surface 301c2 are connected may be positioned lower than the center point P1 of the concave portion 301b, which can enable a wide viewing angle. In some regions of the transparent layer 300 located directly above the wavelength conversion layer 200, the thickness of the transparent layer 300, from its lower surface to its upside, may increase as it goes from the center of the transparent layer 300 toward the lower wall portion 400 (toward the edge in the horizontal direction).

In the case where a single light emitting diode chip 100 is included, the central point P1 of the concave portion 301b may be disposed to be overlap with the light emitting diode chip 100 in the up and down direction. Therefore, light extraction can occur in a balanced manner on both sides.

In the case where a plurality of light emitting diode chips 100 are included, the central point P1 of the concave portion 301b may be disposed between the light emitting diode chips 100, such that the light is guided by the surface of the concave portion 301b located on the upper surface of each light emitting diode chip 100.

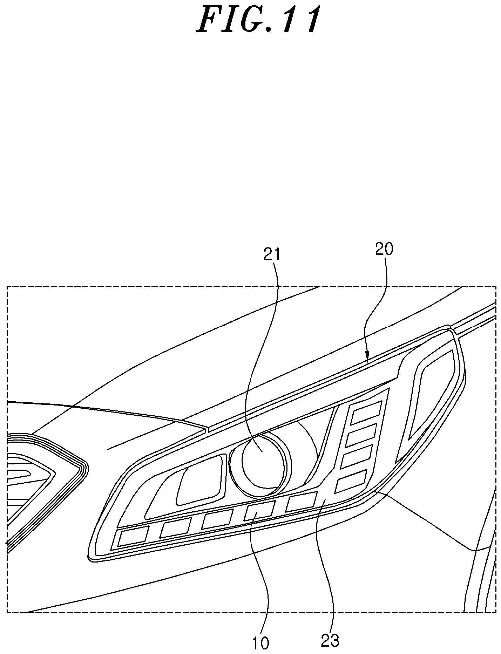

Meanwhile, in addition to the above configuration, according to a tenth embodiment of the present disclosure, the light emitting device 10 can be applied to a vehicle lamp. Hereinafter, with further reference to FIG. 11, the tenth embodiment of the present disclosure will be described. In describing the tenth embodiment, the differences compared to the embodiments described above will be mainly explained, and the same descriptions and reference numerals refer to the embodiments described above.

Referring to FIG. 11, the vehicle lamp 20 may include a combination lamp 23 and, additionally, may further include a main lamp 21. The vehicle lamp 20 can be applied to various parts of the vehicle, such as the headlights, taillights, or side mirror lights.

The main lamp 21 may be the primary light source in the vehicle lamp 20. For example, when the vehicle lamp 20 is used as a headlight, it may serve as a headlight to illuminate the front of a vehicle.

The combination lamp 23 includes light emitting devices 10 and can perform two or more functions. For example, when the vehicle lamp 20 is used as a headlight, the combination lamp 23 may serve as a daytime running light (DRL), turn signal, or the like.

FIG. 11 shows that the combination lamp 23 includes the light emitting device 10, but the main lamp 21 could also be configured to use the light emitting device 10 that employs a light emitting diode or the like.

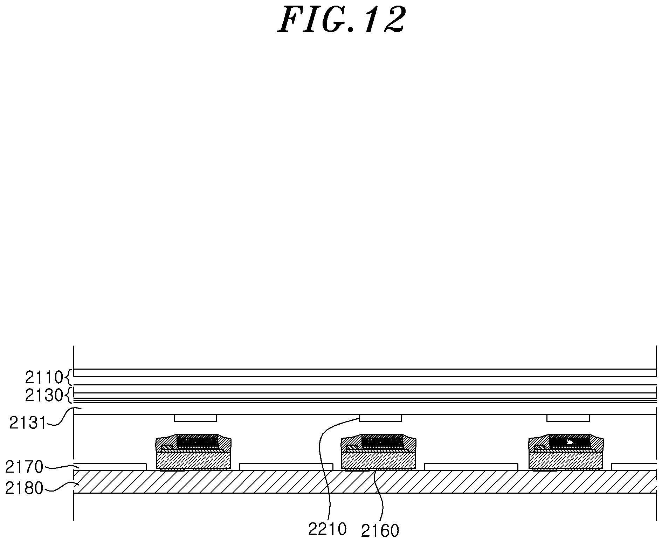

Meanwhile, in addition to the above configuration, according to an eleventh embodiment of the present disclosure, an optical element 2210 is arranged above each light emitting element 2160 at a position corresponding to the light emitting elements 2160 to reflect light emitted from a plurality of light emitting elements 2160 toward the optical elements 2210 and guide the light to the side surfaces, thereby enabling its use in a display device or an indication device. Hereinafter, with further reference to FIG. 12, the eleventh embodiment of the present disclosure will be described. In describing the eleventh embodiment, the differences compared to the embodiments described above will be mainly explained, and the same descriptions and reference numerals refer to the embodiments described above.

In another embodiment, the optical element 2210 may be arranged above each light emitting element 2160 at a position corresponding to the light emitting elements 2160 in the up and down direction to reflect light emitted from the plurality of light emitting elements 2160 toward the optical elements 2210 and guide the light to the side surfaces. The optical elements 2210 corresponding to each light emitting element 2160 may be spaced apart from each other. Since the optical elements 2210 are disposed above the light emitting elements 2160 in positions where light is primarily emitted, the light dispersion efficiency can be increased, thereby preventing luminance deviations and chromaticity deviations from occurring in a unit area. The light emitting elements may be the light emitting diode package of the previous embodiments.

The optical element 2210 may be disposed vertically spaced apart from the light emitting element 2160, and some or all of the separated space may be disposed with a material having a lower refractive index than the optical element 2210. Thus, light extraction efficiency may be improved. The lower refractive index material may be silicon, air, SiO₂, TiO₂, epoxy, polymer, or the like.

Alternatively, although not shown, the optical element 2210 may be disposed in direct contact with the light emitting element 2160. In one example, the optical element 2210 may be disposed on the upper surface of the transparent layer 300 in the previously described embodiments. By covering at least a portion of the transparent layer 300, the optical element 2210 can prevent moisture from penetrating through the cracks in the surface of the transparent layer 300 and provide a long moisture permeation path.

The optical elements 2210 may be shaped as a uniform thickness plate, ensuring that they maintain consistent reflectivity at all points. Alternatively, the optical elements 2210 may have a thickness that is greatest at the center and tapers off toward the edges, which could enhance the reflectivity for a wider range of incident light.

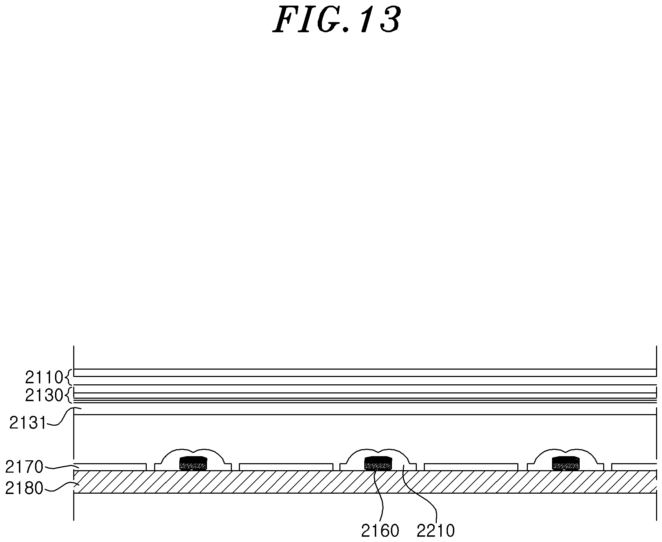

Meanwhile, in addition to the above configuration, according to a twelfth embodiment of the present disclosure, the light emitting device may be applied to a display device. Hereinafter, with further reference to FIG. 13, the twelfth embodiment of the present disclosure will be described. In describing the twelfth embodiment, the differences compared to the embodiments described above will be mainly explained, and the same descriptions and reference numerals refer to the embodiments described above.

The display device of the present embodiment may include a display panel 2110, a backlight unit that provides light to the display panel 2110, and a panel guide that supports the lower edge of the display panel 2110.

The display panel 2110 is not particularly limited and may, for example, be a liquid crystal display panel that includes a liquid crystal layer. A gate drive PCB that supplies drive signals via a gate line may be disposed at the edge of the display panel 2110. Here, the gate drive PCB may be formed directly on the thin film transistor (TFT) substrate, rather than on a separate PCB.

The display device of the present embodiment may be used as a backlight unit and may include at least one substrate and a light source module that includes the plurality of light emitting devices 2160. Additionally, the backlight unit may further include a bottom cover 2180, a reflective sheet 2170, a diffusion plate 2131, and one or more optical sheets 2130.

The bottom cover 2180 may be open upwardly and may support the substrate, the light emitting device 2160, the reflective sheet 2170, the diffusion plate 2131, and one or more optical sheets 2130. The bottom cover 2180 may also be combined with the panel guide. The substrate is disposed below the reflective sheet 2170 and may be arranged surrounded by the reflective sheet 2170. However, it is not limited thereto, and when the reflective material is coated on the surface, the reflective material may be disposed on the reflective sheet 2170. Furthermore, the substrate may be formed as a plurality of substrates, which can be arranged side by side, but this is not limited thereto, and it may also be formed as a single substrate.

The light emitting device 2160 may include at least one of the light emitting devices according to the embodiments of the present disclosure described above. The light emitting devices 2160 may be regularly arranged in a specific pattern on the substrate. Further, an optical element 2210 is placed on each light emitting device 2160 to improve the uniformity of light emitted from one or more light emitting devices 2160.

The diffusion plate 2131 and one or more optical sheets 2130 are positioned on the light emitting device 2160. The light emitted from the light emitting device 2160 may pass through the diffusion plate 2131 and one or more optical sheets 2130, and be supplied to the display panel 2110 in the form of a surface light source.

The examples of the present disclosure have been described above as specific embodiments, but these are only examples, and the present disclosure is not limited thereto, and should be construed as having the widest scope according to the technical spirit disclosed in the present specification. A person skilled in the art may combine/substitute the disclosed embodiments to implement a pattern of a shape that is not disclosed, but it also does not depart from the scope of the present disclosure. In addition, those skilled in the art can easily change or modify the disclosed embodiments based on the present specification, and it is clear that such changes or modifications also belong to the scope of the present disclosure.

## Claims

1. A light emitting diode package (1) comprising:
a light emitting diode chip (100) that generates light of a first color;
a wavelength conversion layer (200) disposed above the light emitting diode chip (100), which generates light of a second color by being excited by the light of the first color;
a transparent layer (300) disposed above the wavelength conversion layer (200); and
a wall portion (400) forming an accommodating space in which the light emitting diode chip (100) and the wavelength conversion layer (200) are accommodated,
wherein the wall portion (400) includes an inner surface (401) surrounding the accommodating space, and
wherein the transparent layer (300) is connected to the inner surface (401) of the wall portion (400) so that the accommodating space is closed from an outside.

2. The light emitting diode package (1) of claim 1, wherein the light emitting diode chip (100) includes:
a semiconductor layer (120); and
a light transmission substrate (110) disposed above the semiconductor layer (120), and
wherein a thickness (t3) of the transparent layer (300) is smaller than a thickness (t1) of the light transmission substrate (110).

3. The light emitting diode package (1) of claim 2, wherein the thickness (t1) of the light transmission substrate (110) ranges from 100µm to 150µm.

4. The light emitting diode package (1) of claim 2, wherein the thickness (t3) of the transparent layer (300) ranges from 30µm to 50µm.

5. The light emitting diode package (1) of claim 1, wherein the light emitting diode chip (100) includes:
a semiconductor layer (120); and
a light transmission substrate (110) disposed above the semiconductor layer (120), and
wherein a thickness (t1) of the light transmission substrate (110) is smaller than a thickness (t2) of the wavelength conversion layer (200).

6. The light emitting diode package (1) of claim 5, wherein the thickness (t2) of the wavelength conversion layer (200) ranges from 120µm to 200µm.

7. The light emitting diode package (1) of claim 1, wherein the wall portion (400) intersects with an edge extension plane (p), which is an imaginary plane extending in a horizontal direction from a bottom edge (a) of the transparent layer (300).

8. The light emitting diode package (1) of claim 7, wherein an upper end of the wall portion (400) includes a sloped surface (410a) that slopes downward toward the outside, and
wherein the sloped surface (410a) intersects with the edge extension plane (p) between upper and lower ends thereof.

9. The light emitting diode package (1) of claim 1, wherein an upper end of the wall portion (400) includes a sloped surface (410a) that slopes downward toward the outside,
wherein the wavelength conversion layer (200) includes a plurality of phosphors (210), and
wherein, in an up and down direction, the phosphor (210) disposed at the uppermost position among the plurality of phosphors (210) is disposed between upper and lower ends of the sloped surface (410a).

10. The light emitting diode package (1) of claim 1, wherein an outer peripheral surface of the wavelength conversion layer (200) and an outer peripheral surface of the transparent layer (300) extend continuously without a notch.

11. The light emitting diode package (1) of claim 1, wherein the light emitting diode chip (100) includes:
a semiconductor layer (120); and
a light transmission substrate (110) disposed above the semiconductor layer (120), and
wherein an outer peripheral surface of the wavelength conversion layer (200) and an outer peripheral surface of the transparent layer (300) extend continuously without a notch.

12. The light emitting diode package (1) of claim 1, wherein at least a portion of the outer peripheral surface of the light emitting diode chip (100) is spaced apart from the inner surface (401) of the wall portion (400).

13. The light emitting diode package (1) of claim 12, wherein the light emitting diode chip (100) includes:
a semiconductor layer (120); and
a light transmission substrate (110) disposed above the semiconductor layer (120), and
wherein a thickness (t1) of the light transmission substrate (110) is greater than a horizontal separation distance between an upper end of an outer peripheral surface of the light transmission substrate (110) and an upper end of the inner surface (401) of the wall portion (400).

14. The light emitting diode package (1) of claim 1, further comprising;
a light transmissive layer (700) that transmits the light of the first color to the wavelength conversion layer (200),
wherein the light transmissive layer (700) is disposed between the light emitting diode chip (100) and the wavelength conversion layer (200).

15. The light emitting diode package (1) of claim 14, wherein a thickness (t4) of the light transmissive layer (700) is smaller than a thickness (t3) of the transparent layer (300).

16. The light emitting diode package (1) of claim 1, wherein the wavelength conversion layer (200) is formed of one or more of PIS (phosphor in silicone), PIG (phosphor in glass), and Si (silicone).

17. A light emitting diode package (1) comprising:
a light emitting diode chip (100) that generates light of a first color;
a wavelength conversion layer (200) disposed above the light emitting diode chip (100), which generates light of a second color by being excited by the light of the first color;
a wall portion (400) forming an accommodating space in which the light emitting diode chip (100) and the wavelength conversion layer (200) are accommodated; and
a transparent layer (300) disposed above the wavelength conversion layer (200) and the wall portion (400) to close the accommodating space from an outside,
wherein the wall portion (400) includes an inner surface (401) surrounding the accommodating space, and
wherein an outer peripheral surface of the transparent layer (300) is disposed outside the inner surface (401) of the wall portion (400).

18. The light emitting diode package (1) of claim 17, wherein the outer peripheral surface of the transparent layer (300) and an outer peripheral surface of the wall portion (400) extend continuously without a notch.

19. The light emitting diode package (1) of claim 17, wherein a plurality of protrusions (301a) is formed on a surface (301) of the transparent layer (300) exposed to the outside.

20. A light emitting diode package (1) comprising:
a light emitting diode chip (100) that generates light of a first color;
a wavelength conversion layer (200) disposed above the light emitting diode chip (100), which generates light of a second color by being excited by the light of the first color;
a wall portion (400) forming an accommodating space in which the light emitting diode chip (100) and the wavelength conversion layer (200) are accommodated; and
a transparent layer (300) disposed above the wavelength conversion layer (200) and the wall portion (400) to close the accommodating space from an outside,
wherein a surface (301) of the transparent layer (300) has an outwardly convex curved shape.
